# EUROPEAN PATENT SPECIFICATION

(11) **EP 2 267 179 B1**
(45) Date of publication and mention of the grant of the patent: **26.12.2012**
(21) Application number: 09163730.6
(22) Date of filing: 25.06.2009
(51) Int. Cl.: C23C 14/50, H01L 21/67, C23C 14/28, C23C 14/54

(54) **Target cooling device**
Zielkühlvorrichtung
Dispositif de refroidissement de cible

(43) Date of publication of application: 29.12.2010
(73) Proprietor: Solmates B.V., 7522 NB Enschede (NL)
(72) Inventor: Broekmaat, Joska Johannes, 7511 DS Enschede (NL); Janssens, Jan Arnoud, 7412 DL Deventer (NL); Dekkers, Jan Matthijn, 7611 AN Aadorp (NL)
(74) Representative: 't Jong, Bastiaan Jacob

(56) References cited:
- EP-A- 0 526 326
- US-A- 5 207 884
- US-A1- 2004 089 534
- US-A1- 2005 178 334

## Description

The invention relates to a laser deposition device, comprising at least one target, a substrate arranged opposite of the at least one target and a laser for generating a laser beam, which beam is directed on the target, such that a plasma plume of target material is generated and is deposited onto the substrate.

Laser deposition, in particular pulsed laser deposition (PLD) is a known technique for arranging a coating on an object. With this technique material of a target material is ablated by a laser, such that a plasma plume of this target material is generated. This plasma plume then is deposited on a substrate resulting in a coating of the target material on the substrate.

PLD was at first developed for coating small substrate surfaces, typically 10 millimeters by 10 millimeters. This is typically used in research environments, where small substrates are coated with all kinds of materials with high thin film quality.

Resulting from this research a need to coat larger surfaces originated. This has resulted in innovative techniques with which surfaces having a typical diameter of several inches or more can be coated.

In order to coat some substrate materials with PLD with the correct material properties, such as crystal structure and texture, it is often necessary to heat the substrate to temperatures of typically 200°C - 1000°C.

When a small substrate surface of about 10x10 millimeters is heated up to 200°C - 1000°C, the heat radiation does not influence too much the target material arranged opposite to the substrate material. However, as the size of the substrate surface is increased, the heat radiation is also increased resulting in an unacceptable influence on the target material. This could result in early evaporation of components of the target material, such that the deposited coating on the substrate is of another composition than the original composition of the target material.

Another problem is target cracking. The target material could be of a material which has a poor heat conduction. When such a material is heated, the temperature differences in the material could lead to cracks in the material. Cracking can also occur if the target material undergoes a phase transition due to heating. Cracking can furthermore occur if the bonding material between the target material and the target plate have different thermal expansion coefficients.

In other cases the target material has to be moved or rotated as a result of the used PLD technique. In such cases, cooling of a moving target is difficult.

A third problem with heating large substrate surfaces, is that not only the target material, but also the surrounding vacuum chamber and heat sensitive components, such as electric motors and rubber fittings, get heated to undesired temperatures.

The above mentioned disadvantage are at least partially resolved by another invention of the present applicant, which invention is described in an earlier, non published application. According to this earlier invention, a heat shield is arranged between the substrate and the target for shielding the target from being heated by the heated substrate. The heat shield comprises at least one passage opening for passage of at least the generated plasma plume.

Although this earlier invention reduces the heating of the target material considerably, in certain circumstances the target material is still heated to undesired temperatures.

US 5 207 884 is also describing a laser ablation device of several targets on a rotatable target frame having a base frame with cooling tubes to continuously cool the target and represents a close prior art document.

Accordingly it is an object of the invention to further reduce or even prevent the heating of the target material, such that high temperature large area PLD is possible.

This object is achieved by the invention, which is characterized by a base frame, a rotatable target frame with at least two target holders arranged in the base frame and at least one cooling device arranged to the base frame, which cooling device can be moved relative to the target frame to bring the cooling device in heat exchanging contact with the target frame.

By arranging the cooling means to the base frame, the cooling means are stationary. This facilitates a reliable connection of for example supply lines to the cooling means. Furthermore by being able to move the cooling device relative to the target frame, the cooling means can be brought in heat exchanging contact with the target frame and be brought out of contact, such that the target frame can be rotated in order to bring another target opposite of the substrate.

The heat absorbed by the target is dissipated through the target frame to the cooling means. This ensures that the targets are cooled during the deposition.

In an embodiment of the device according to the invention, the target holder comprises a mounting base for mounting a target material and an axle arranged to the mounting base, wherein the axle is mounted in the rotatable target frame.

In particular for depositing on large substrate surfaces, it is common to rotate the target during deposition. This ensures an even ablation of target material from the target. According to the invention the target material is arranged on a mounting base, which has an axle for rotating the mounting base and accordingly the target.

Preferably the ratio of the cross section of the axle of the target holder and the surface of the target holder is smaller than 1:4. By having a relatively thick axle in respect to the surface of the target, the heat picked up by the target is easily dissipated through the relative thick axle to the target frame, which is in turn in heat exchanging contact with the cooling device.

In a preferred embodiment of the device according to the invention the rotatable target frame comprises a disc having a main axle and wherein the at least two target holders are arranged to the disc.

The disc shaped target frame has the advantage of a large heat capacity and also the advantage of providing a heat shield for objects on the opposite side of the disc shaped target frame. It furthermore provides a solid mounting base for the targets and other components as well as a sufficient contact surface for the cooling device.

In another preferred embodiment the cooling device and / or the rotatable target frame are flexibly arranged to the base frame, in order to compensate for alignment differences between the cooling means and the target frame.

In still another embodiment of the invention the cooling device is spring mounted to the base frame. By arranging the liquid cooled block with springs to the base frame, it is possible for the cooling block to compensate for small dimensional differences and alignment differences to ensure a full heat exchanging contact of the cooling block with the target frame. As laser deposition is typically performed in a vacuum, heat dissipation by convection is minimal and all exchange of heat must be by direct contact.

In still another preferred embodiment of the invention, the cooling device comprises at least one liquid cooled block. With liquid a substantial amount of heat can easily be transferred to outside of the laser depositing device.

In yet another embodiment, the laser depositing device according to the invention comprises a heater for heating the substrate.

In still another preferred embodiment of the invention a heat shield is arranged around the at least one target, the heat shield comprising a opening for passage of the laser beam and generated plasma plume. Preferably the heat shield is a cylindrical body enveloping the at least one target. Such a heat shield reduces further the heating of the target, but also provides a cooled chamber around the target, as the heat shield is in direct contact with the target frame and accordingly with the cooling device.

These and other features of the invention will be elucidated in conjunction with the accompanying drawings.

Figure 1 shows a cross sectional and perspective view of a first embodiment of the invention.

Figure 2 shows a cross sectional view along the lines II-II shown in figure 1.

Figure 3 show a perspective view of a second embodiment of the invention.

Figure 4 shows a variant of the embodiment according to figure 2.

Figure 5 shows a third embodiment of the invention in cross sectional view.

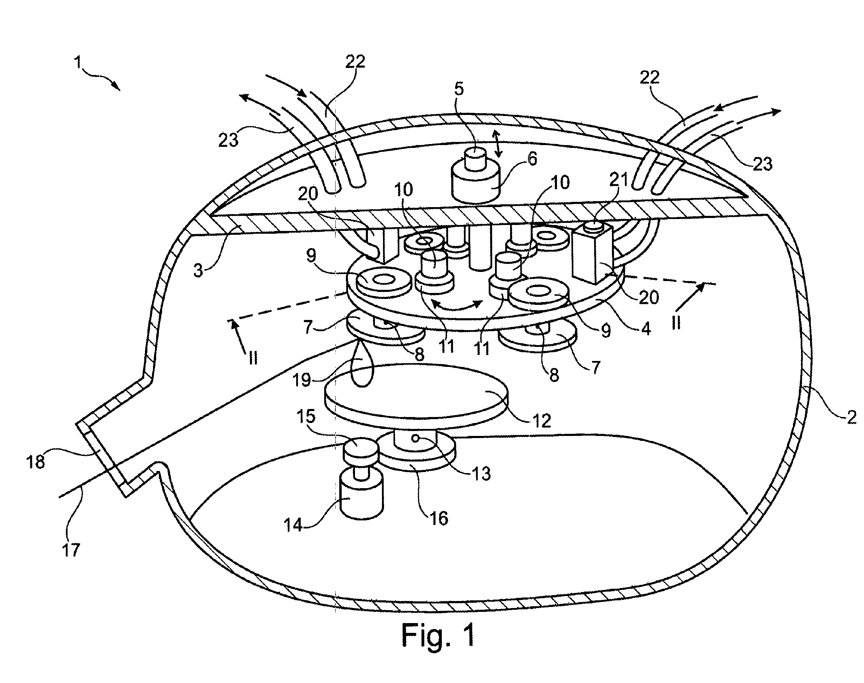

Figure 1 shows a first embodiment 1 of the invention. This embodiment comprises a vacuum chamber 2. In this chamber 2 a base frame 3 is arranged. Depending from this base frame 3 is a target frame 4. This target frame 4 has an axle 5, which is rotatably arranged in the base frame 3. The axle 5 is driven by an actuator 6, which can also move the axle 5 in axial direction.

Four target holders 7 are arranged by a respective axle 8 on the target frame 4. A gear 9 is arranged at the end of each axle 8. This gear 9 is driven by a motor 10 though a second gear 11.

A substrate 12 is arranged below one of the target holders 7. This substrate 12 is mounted on an axle 13, which is driven by a motor 14 through gears 15 and 16.

When applying laser deposition, a laser beam 17 is directed through a window 18 in the vacuum chamber 2 onto the target 7. The target material is heated and a plume 19 of target material is generated. This plume 19 is then deposited on the substrate 12. In order to have a uniform layer on the substrate 12, the laser beam 17 is moved in radial direction over the target surface 7, while the substrate 12 is rotated by the motor 14. At the same time the target holder 7 is rotated, such that the target material is ablated evenly by the laser beam 17.

A number of cooling blocks 20 are in contact with the target frame 4 in order to cool the target material. These cooling blocks 20 are spring 21 mounted to the base frame 3 and pressed to the target frame 4 by pulling the target frame 4 upwards by actuator 6.

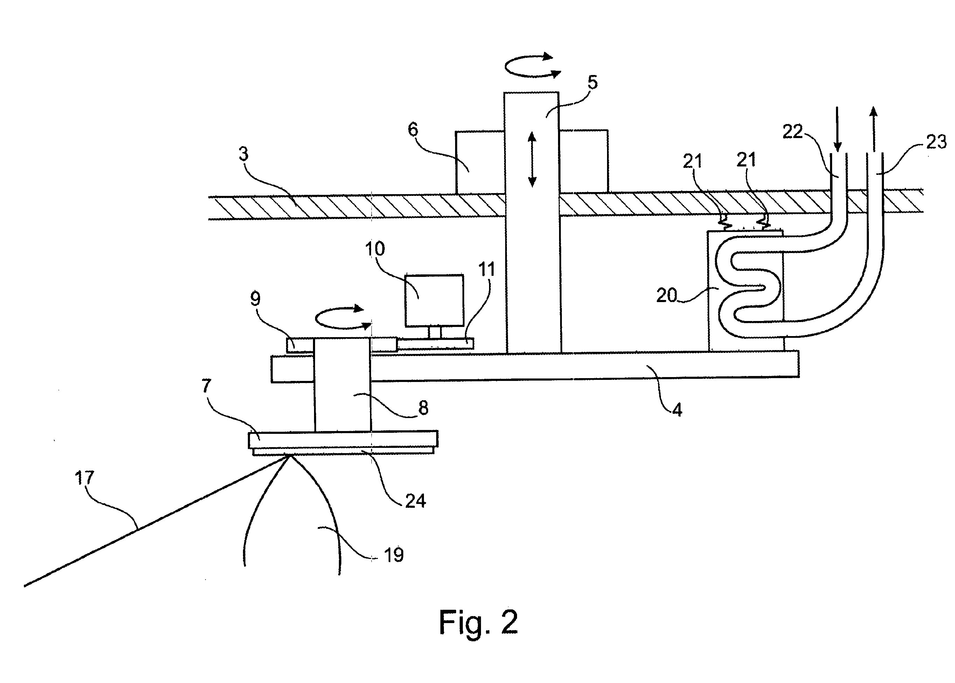

In figure 2 a cross sectional view along the line II-II of figure 1 is shown. From this figure 2 it is clear that the cooling block 20 can be pressed to the target frame 4 by lifting the target frame 4 up.

The cooling block 20 has a meandering channel 21, which is supplied by supply line 22 with a cooled liquid. Heat from the target material 24 is dissipated to the target holder 7, the relatively thick axle 8 and to the target frame 4. This target frame 4 is a disc of heat conducting material, which conducts the heat from the target 24 to the cooling block 20. The liquid in the cooling block 20 is then heated and the heated liquid is discharged through discharge line 23.

The advantage of this invention is that the cooling blocks 20 can be fixed to the base frame 3, while the target frame 4 can still be rotated. If for example another target material 24 must be used, the target frame 4 is lowered by the actuator 6, then rotated such that the correct target material 24 is over the substrate 12, and finally the target frame 4 is moved up again, such that the static cooling blocks 20 are pressed against the target frame 4 in heat exchanging contact.

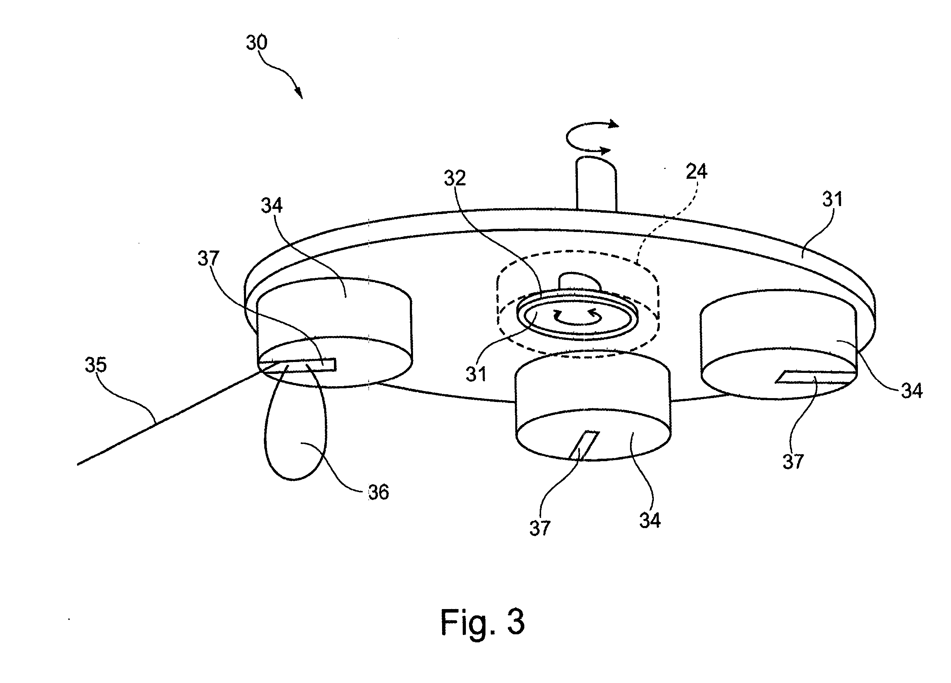

Figure 3 shows a second embodiment 30 of the invention. Only the rotatable target frame 31 is shown, as the other components of this embodiment correspond with the embodiment of figures 1 and 2.

Four target holders 32 are arranged on the target frame 31. Each target holder 32 can be rotated and carries a target material 33.

A cylindrical housing 34 is arranged around each target holder 32. This cylindrical housing 34 envelopes the respective target holder 32 and is in heat exchanging contact with the target frame 31. This creates a cooled space around the target holder 32.

Each cylindrical housing 34 is provided with a slot shaped opening 37 for passage of a laser beam 35 and plasma plume 36 of target material 33.

The housing 34 reduces cross contamination between the four target materials 33 present on the target frame 4.

Optionally, the slot shaped openings 37 could be closed for the target holders 32, which are not being used. This even prevents contamination of the target material 33.

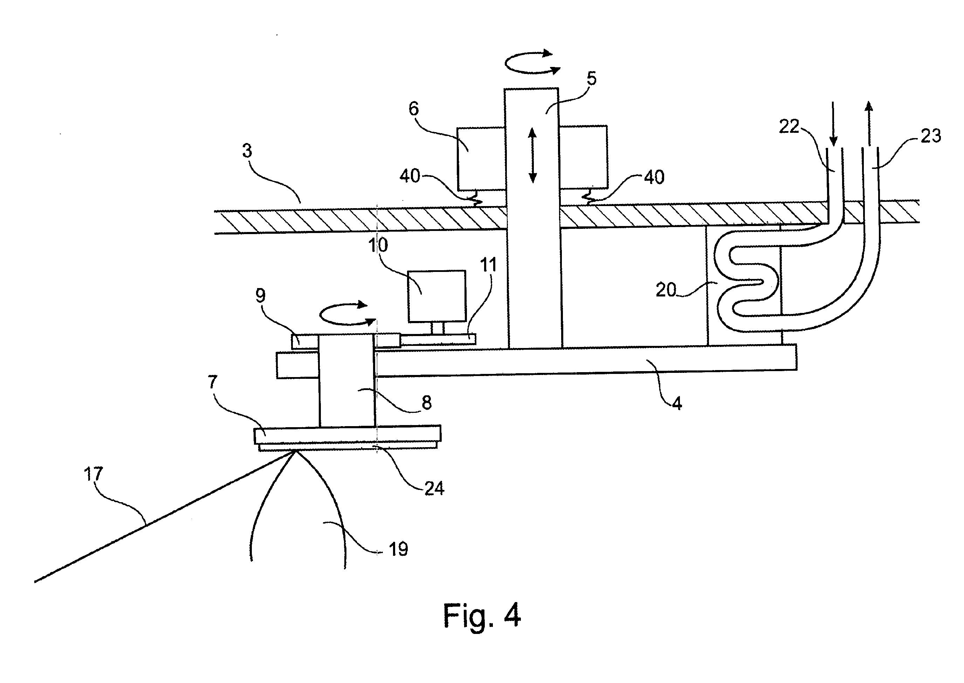

Figure 4 shows a variant to the embodiment according to figure 2. The same features have been provided with the same reference signs.

In this variant to the embodiment according to figure 2, the cooling block 20 is arranged directly to the base frame 3. In order to still be able to take into account differences in dimensions and alignment differences, the actuator 6, which rotates and translates the axle 5 of the target frame 4 has been spring mounted to the base frame 3 by springs 40. As a result the target frame 4 can tilt relative to the base frame 3.

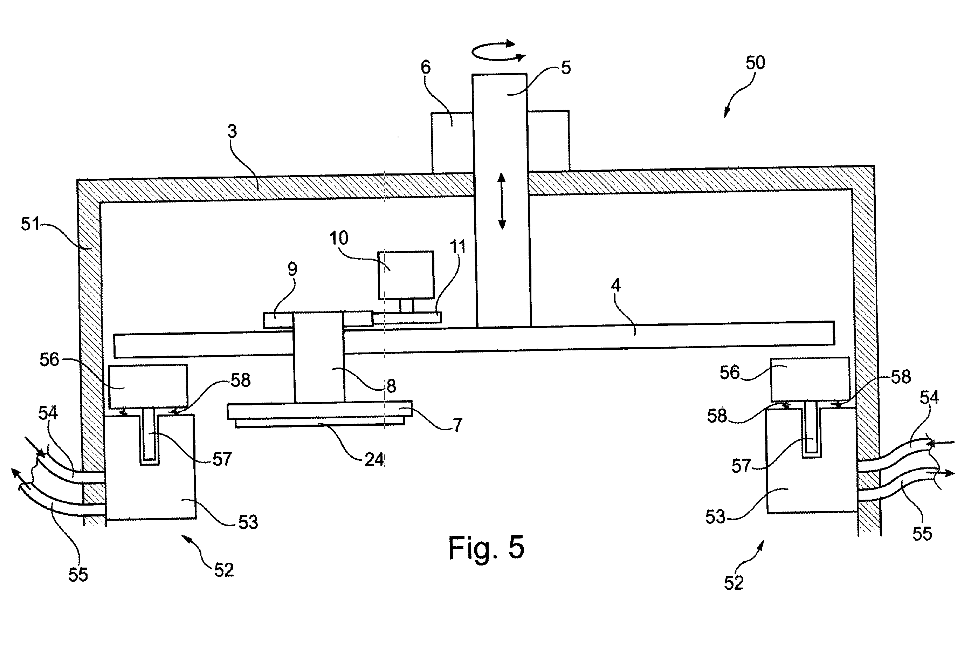

Figure 5 shows a third embodiment 50 of the laser deposition device according to the invention. Features of this third embodiment corresponding with features of the embodiment according figure 2 have been provided with the same reference signs.

In this third embodiment 50 the base frame 3 has been provided with a vertical, circumferential wall 51. This wall 51 is arranged around the target frame 4.

On the vertical wall 51 two cooling blocks 52 are arranged. Each cooling block 52 has a bottom part 53 through which a cooling liquid flows supplied by supply line 54 and discharge line 55. A top part 56 of the cooling block 52 is guided by a rod 57 in the bottom part 53. This guide rod 57 ensures that the top part 56 and bottom part 53 stay aligned to each other and also contributes to a good heat transfer between the top part 56 and bottom part 53.

It is possible to cool the top part 56 separately by separate cooling lines, similar to the cooling blocks 20 of figure 2. Likewise it is possible to have a guide rod arranged in the cooling blocks 20 of figure 2 to have these cooling blocks 20 aligned relative to the base frame 3.

Springs 58 are arranged between the top part 56 and the bottom part 53, such that difference in alignment or dimensional differences between the top part 56 of a cooling block 52 and the target frame 4 can be taken into account.

## Claims

1. Laser deposition device (1; 30; 50), comprising at least two targets (7; 33), a substrate (12) arranged opposite of the at least two targets (7; 33) and a laser for generating a laser beam (17), which beam (17) is directed on one of the targets (7, 33)_{,} such that a plasma plume (19) of target material is generated and is deposited onto the substrate (12), and a base frame (3), a rotatable target frame (4, 31) with at least two target holders (7; 32) arranged in the target frame (4; 31), **characterized by** at least one cooling device (20; 52) arranged to the base frame (3), which cooling device (20; 52) can be moved relative to the target frame (4; 31) to bring the cooling device (20, 52) in direct heat exchanging contact with the target frame (4).

2. Laser depositing device (1; 30; 50) according to claim 1, wherein the target holder (7; 32) comprises a mounting base for mounting a target material (7; 33) and an axle (8) arranged to the mounting base, wherein the axle (8) is mounted in the rotatable target frame (4; 31).

3. Laser depositing device (1; 30; 50) according to claim 2, wherein the ratio of the cross section of the axle (8) of the target holder (7; 32) and the surface of the target holder (7; 32) is smaller than 1:4.

4. Laser depositing device (1; 30; 50) according to any of the preceding claims, wherein the rotatable target frame (4) comprises a disc (4) having a main axle (5) and wherein the at least two target holders (7; 32) are arranged to the disc (4).

5. Laser depositing device (1; 30; 50) according to any of the preceding claims, wherein the cooling device and / or the rotatable target frame are flexibly arranged to the base frame, in order to compensate for alignment differences between the cooling means and the target frame.

6. Laser depositing device according to any of the preceding claims, wherein the cooling device (20; 52) is spring (21; 58) mounted to the base frame (3).

7. Laser depositing device (1; 30; 50) according to claim 6, wherein the cooling device (20; 52) comprises at least one liquid cooled block (20; 52).

8. Laser depositing device (1; 30; 50) according to any of the preceding claims, comprising a heater for heating the substrate (12).

9. Laser depositing device (30) according to any of the preceding claims, wherein a heat shield (34) is arranged around the at least one target (33), the heat shield (34) comprising a opening (37) for passage of the laser beam (35) and generated plasma plume (36).

10. Laser depositing device (30) according to claim 9, wherein the heat shield (34) is a cylindrical body enveloping the at least one target (33).

## Patentansprüche

1. Laserabscheidungseinrichtung (1; 30; 50), die mindestens zwei Ziele (7; 33) umfasst, ein gegenüber den mindestens zwei Zielen (7; 33) angeordnetes Substrat (12) und einen Laser zum Generieren eines Laserstrahls (17), wobei der Strahl (17) auf eines der Ziele (7; 33) gerichtet wird, so dass eine Plasmawolke (19) aus Zielmaterial generiert und auf dem Substrat (12) abgeschieden wird, und einen Basisrahmen (3), einen drehbaren Zielrahmen (4; 31) mit mindestens zwei in dem Zielrahmen (4; 31) angeordneten Zielhalterungen (7; 32),
**gekennzeichnet durch** mindestens eine Kühleinrichtung (20; 52), die an dem Basisrahmen (3) angeordnet ist, wobei die Kühleinrichtung (20; 52) relativ zu dem Zielrahmen (4; 31) bewegt werden kann, um die Kühleinrichtung (20; 52) in direkten wärmeaustauschenden Kontakt mit dem Zielrahmen (4) zu bringen.

2. Laserabscheidungseinrichtung (1; 30; 50) nach Anspruch 1, wobei die Zielhalterung (7; 32) eine Befestigungsbasis zum Befestigen eines Zielmaterials (7; 33) und eine an der Befestigungsbasis angeordnete Achse (8) umfasst, wobei die Achse (8) in dem drehbaren Zielrahmen (4; 31) montiert ist.

3. Laserabscheidungseinrichtung (1; 30; 50) nach Anspruch 2, wobei das Verhältnis des Querschnitts der Achse (8) der Zielhalterung (7; 32) und der Oberfläche der Zielhalterung (7; 32) kleiner als 1:4 ist.

4. Laserabscheidungseinrichtung (1; 30; 50) nach einem der vorhergehenden Ansprüche, wobei der drehbare Zielrahmen (4) eine Scheibe (4) mit einer Hauptachse (5) umfasst und wobei die mindestens zwei Zielhalterungen (7; 32) an der Scheibe (4) angeordnet sind.

5. Laserabscheidungseinrichtung (1; 30; 50) nach einem der vorhergehenden Ansprüche, wobei die Kühleinrichtung und/oder der drehbare Zielrahmen flexibel an dem Basisrahmen angeordnet sind, um Ausrichtungsdifferenzen zwischen dem Kühlmittel und dem Zielrahmen zu kompensieren.

6. Laserabscheidungseinrichtung nach einem der vorhergehenden Ansprüche, wobei die Kühleinrichtung (20; 52) durch eine Feder (21; 58) an dem Basisrahmen (3) montiert ist.

7. Laserabscheidungseinrichtung (1; 30; 50) nach Anspruch 6, wobei die Kühleinrichtung (20; 52) mindestens einen flüssigkeitsgekühlten Block (20; 52) umfasst.

8. Laserabscheidungseinrichtung (1; 30; 50) nach einem der vorhergehenden Ansprüche, umfassend eine Heizvorrichtung zum Erhitzen des Substrats (12).

9. Laserabscheidungseinrichtung (30) nach einem der vorhergehenden Ansprüche, wobei ein Wärmeschild (34) um das mindestens eine Ziel (33) herum angeordnet ist, wobei der Wärmeschild (34) eine Öffnung (37) für eine Passage des Laserstrahls (35) und die generierte Plasmawolke (36) umfasst.

10. Laserabscheidungseinrichtung (30) nach Anspruch 9, wobei der Wärmeschild (34) ein zylindrischer Körper ist, der das mindestens eine Ziele (33) einhüllt.

## Revendications

1. Dispositif de dépôt par laser (1 ; 30 ; 50), comprenant au moins deux cibles (7 ; 33), un substrat (12) aménagé en regard des au moins deux cibles (7 ; 33) et un laser pour générer un faisceau laser (17), lequel faisceau (17) est dirigé sur l'une des cibles (7 ; 33), de sorte qu'un panache de plasma (19) du matériau cible soit généré et déposé sur le substrat (12), et
un châssis de base (3), un châssis de cible rotatif (4, 31) avec au moins deux porte-cibles (7 ; 32) aménagés dans le châssis de cible (4 ; 31), **caractérisé par** au moins un dispositif de refroidissement (20 ; 52) aménagé sur le châssis de base (3), lequel dispositif de refroidissement (20 ; 52) peut être déplacé par rapport au châssis de cible (4 ; 31) pour amener le dispositif de refroidissement (20 ; 52) en contact direct d'échange de chaleur avec le châssis de cible (4).

2. Dispositif de dépôt par laser (1 ; 30 ; 50) selon la revendication 1, dans lequel le porte-cible (7 ; 32) comprend une base de montage pour monter un matériau cible (7 ; 33) et un axe (8) aménagé sur la base de montage, dans lequel l'axe (8) est monté dans le châssis de cible rotatif (4 ; 31).

3. Dispositif de dépôt par laser (1 ; 30 ; 50) selon la revendication 2, dans lequel le rapport de la section transversale de l'axe (8) du porte-cible (7 ; 32) à la surface du porte-cible (7 ; 32) est plus petit que 1:4.

4. Dispositif de dépôt par laser (1 ; 30 ; 50) selon l'une quelconque des revendications précédentes, dans lequel le châssis de cible rotatif (4) comprend un disque (4) ayant un axe principal (5) et dans lequel les au moins deux porte-cibles (7 ; 32) sont aménagés sur le disque (4).

5. Dispositif de dépôt par laser (1 ; 30 ; 50) selon l'une quelconque des revendications précédentes, dans lequel le dispositif de refroidissement et/ou le châssis de cible rotatif est ou sont aménagés de manière flexible sur le châssis de base afin de compenser les différences d'alignement entre les moyens de refroidissement et le châssis de cible.

6. Dispositif de dépôt par laser (1 ; 30 ; 50) selon l'une quelconque des revendications précédentes, dans lequel le dispositif de refroidissement (20 ; 52) est monté sur le châssis de base (3) via un ressort (21 ; 58).

7. Dispositif de dépôt par laser (1 ; 30 ; 50) selon la revendication 6, dans lequel le dispositif de refroidissement (20 ; 52) comprend au moins un bloc (20 ; 52) refroidi par un liquide.

8. Dispositif de dépôt par laser (1 ; 30 ; 50) selon l'une quelconque des revendications précédentes, comprenant un dispositif de chauffage pour chauffer le substrat (12).

9. Dispositif de dépôt par laser (30) selon l'une quelconque des revendications précédentes, dans lequel un bouclier thermique (34) est aménagé autour de la au moins une cible (33), le bouclier thermique (34) comprenant une ouverture (37) pour le passage du faisceau laser (35) et du panache de plasma (36) généré.

10. Dispositif de dépôt par laser (30) selon la revendication 9, dans lequel le bouclier thermique (34) est un corps cylindrique enveloppant la au moins une cible (33).
